# EUROPEAN PATENT APPLICATION

(11) **EP 4 220 722 A1**
(43) Date of publication of application: **02.08.2023**
(21) Application number: 23153430.6
(22) Date of filing: 26.01.2023
(51) Int. Cl.: H01L 27/146

(54) **IMAGE SENSOR AND ELECTRONIC DEVICE INCLUDING THE IMAGE SENSOR**

(30) Priority: 28.01.2022 KR 20220013624
(71) Applicant: Samsung Electronics Co., Ltd., Gyeonggi-do 16677 (KR)
(72) Inventor: YUN, Seokho, 16678, Suwon-si, (KR); ROH, Sookyoung, 16678, Suwon-si, (KR); LEE, Sangyun, 16678, Suwon-si, (KR); LEE, Junho, 16678, Suwon-si, (KR); CHO, Choonlae, 16678, Suwon-si, (KR); CHA, Jungho, 16678, Suwon-si, (KR)
(74) Representative: Elkington and Fife LLP

(57) **Abstract**

An image sensor includes a sensor substrate including a plurality of light sensing cells configured to sense light, and a color filter array provided on the sensor substrate. The color filter includes a plurality of filters provided to respectively face the plurality of light sensing cells to filter light of different wavelengths and a fence structure configured to separate the plurality of filters from each other. A width of the fence structure may have a plurality of different values according to types of two filters provided adjacent to each other with the width interposed therebetween. Crosstalk between adjacent cells may be reduced by the image sensor.

## Description

### FIELD OF THE INVENTION

The disclosure relates to an image sensor and an electronic device including the image sensor.

### BACKGROUND OF THE INVENTION

Recently, in accordance with the requirements for miniaturization and high resolution of image sensors, a pixel density has been increased and pixels have been miniaturized. As a pixel pitch has been extremely reduced to equal to or less than 1 µm, methods have been sought to reduce a sensitivity decrease in low illuminance and color mixing due to crosstalk between adjacent cells.

As a solution to the sensitivity decrease and the color mixing, a structure of isolating adjacent pixels has been used. Meanwhile, in order to maintain the overall optical characteristics as a pixel is miniaturized, a volume ratio occupied by the isolation structure tends to decrease in proportion to the high pixel size.

### SUMMARY OF THE INVENTION

Provided are an image sensor having an isolation structure capable of reducing crosstalk between adjacent cells and an electronic device including the image sensor.

Additional aspects will be set forth in part in the description which follows and, in part, will be apparent from the description, or may be learned by practice of the presented embodiments of the disclosure.

According to an aspect of the disclosure, there is provided an image sensor including: a sensor substrate including a plurality of light sensing cells configured to sense light, and a color filter array provided on the sensor substrate, the color filter array including: a plurality of filters provided to respectively face the plurality of light sensing cells to filter light of different wavelengths, and a fence structure configured to separate the plurality of filters from each other, wherein a width of the fence structure interposed between two adjacent filters, among the plurality of filters, has a plurality of different values according to a characteristics of each of the two adjacent filters, and wherein a difference between a maximum value and a minimum value among the plurality of values is equal to or greater than 20 nm.

The fence structure may include a material having a first refractive index lower than a second refractive index of each of the plurality of filters.

The plurality of filters may include a red filter, a first green filter, a second green filter, and a blue filter arranged in a Bayer pattern.

The fence structure may have a first width between the red filter and the first green filter and a second width between the first green filter and the blue filter, the first width being greater than the second width.

The fence structure may have a third width between the red filter and the second green filter and a fourth width between the second green filter and the blue filter, the third width being greater than the fourth width.

A distance between centers of pixels adjacent to each other among a plurality of pixels may be equal to or less than 0.6 µm, and wherein the fence structure may have two widths in a range from 50 nm to 200 nm.

The first green filter and the second green filter may have a first area smaller than a second area of the blue filter and greater than a third area of the red filter.

The sensor substrate may include an isolation structure configured to electrically separate the plurality of light sensing cells and arranged corresponding to the fence structure.

A width of the isolation structure may vary according to a type of a filter facing two adjacent light sensing cells, between which the isolation structure is interposed.

The plurality of light sensing cells may include a red pixel, a first green pixel, a second green pixel, and a blue pixel facing the red filter, the first green filter, the second green filter, and the blue filter, respectively, and wherein a first width of the isolation structure between the red pixel and the first green pixel may be less than a second width of the isolation structure between the first green pixel and the blue pixel.

A third width of the isolation structure between the red pixel and the second green pixel is less than a fourth width of the isolation structure between the second green pixel and the blue pixel.

The first green filter and the second green filter may have a first area greater than a second area of the red pixel, and wherein the second area of the red pixel may be greater than a third area of the blue pixel.

A distance between centers of pixels adjacent to each other among a plurality of pixels may be equal to or less than 0.6 µm, and wherein the isolation structure may have two widths in a range from 50 nm to 180 nm.

The fence structure and the isolation structure may be vertically connected to each other.

The plurality of filters may include a red filter group including four red filters, a first green filter group including four first green filters, a second green filter group including four second green filters and a blue filter group including four blue filters, wherein the red filter group, the first green filter group, the second green filter group, and the blue filter group may be arranged in a Bayer pattern.

A width of the fence structure between filters of a same color may be different from a width of the fence structure between filters of different colors.

Widths of the fence structure between filters of a same color may be different from each other in two or more filter groups.

A width of the fence structure between the red filter and the first green filter adjacent to each other between the red filter group and the first green filter group may be different from a width of the fence structure between the first green filter and the blue filter adjacent to each other between the first green filter group and the blue filter group.

The sensor substrate may include an isolation structure configured to electrically separate the plurality of light sensing cells and face the fence structure.

A width of the isolation structure may vary according to a type of a filter facing two adjacent light sensing cells, between which the isolation structure is interposed.

A shape of a light incident surface of at least one of the plurality of filters and the plurality of light sensing cells may include a circular shape, an oval shape, or a rectangular shape with rounded corners.

The image sensor may further include a micro lens array provided on the color filter array.

The image sensor may further include a meta lens array provided on the color filter array, the meta lens array comprising a plurality of meta lenses respectively designed to exhibit certain focal lengths with respect to red light, green light, and blue light.

The image sensor may further include a color separation lens array provided on the color filter array and configured to separate red light, green light, and blue light among an incident light and collect the red light, the green light, and the blue light in different pixels among a plurality of pixels.

The color separation lens array may include a plurality of regions provided to face the plurality of filters, respectively, and wherein one or more nanoposts having a dimension of a sub-wavelength are provided in each of the plurality of regions.

The color separation lens array may include a plurality of regions provided to face the plurality of filters, respectively, wherein a pattern structure is provided in each of the plurality of regions, the pattern structure comprising a first dielectric having a first refractive index and formed in a first form and a second dielectric having a second refractive index less than the first refractive index and filled in gaps of the first dielectric formed in the first form, and wherein the first form is determined such that the first dielectric is present in any vertical cross-section of the pattern structure.

According to another aspect of the disclosure, there is provided an electronic device including an image sensor configured to convert an optical image into an electrical signal and a processor configured to control an operation of the image sensor and process a signal generated by the image sensor, wherein the image sensor includes: a sensor substrate comprising a plurality of light sensing cells configured to sense light and a color filter array provided on the sensor substrate, the color filter array including: a plurality of filters provided to respectively face the plurality of light sensing cells to filter light of different wavelengths, and a fence structure configured to separate the plurality of filters from each other, wherein a width of the fence structure interposed between two adjacent filters, among the plurality of filters, has a plurality of different values according to a characteristics of each of the two adjacent filters, and wherein a difference between a maximum value and a minimum value among the plurality of values is equal to or greater than 20 nm.

According to another aspect of the disclosure, there is provided an image sensor including: a sensor substrate comprising a plurality of light sensing cells configured to sense light, a plurality of color filters provided to face the plurality of light sensing cells in a one to one manner, the plurality of color filters including a first color filter, a second color filter and a third color filter, a first fence structure configured to separate the first color filter and the second color filter that are adjacent to each other, and a second fence structure configured to separate the second color filter and the third color filter that are adjacent to each other, wherein a width of the first fence structure is different from a width of the second fence structure.

A width of the first fence structure may be greater from a width of the second fence structure.

The first color filter may be a red color filter, the second color filter may be a green color filter, and the third color filter may be a blue color filter.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a block diagram schematically illustrating an image sensor according to an example embodiment;
FIG. 2 is a plan view illustrating a color arrangement by a pixel array of the image sensor according to an example embodiment;
FIGS. 3A and 3B are cross-sectional views illustrating a schematic structure of the image sensor according to example embodiments, respectively showing rows of different pixel arrangements;
FIG. 4 is a plan view illustrating a structure of a color filter array provided in the image sensor according to an example embodiment;
FIG. 5 is a plan view illustrating a structure of a sensor substrate provided in the image sensor according to an example embodiment;
FIGS. 6A and 6B are cross-sectional views illustrating a schematic structure of an image sensor according to another example embodiment, respectively showing rows of different pixel arrangements;
FIG. 7 is a plan view illustrating a structure of a color filter array provided in the image sensor of FIGS. 6A and 6B;
FIG. 8 is a plan view showing a structure of a sensor substrate provided in the image sensor of FIGS. 6A and 6B;
FIGS. 9A and 9B are graphs illustrating a spectrum of light transmitted through a color filter array of an image sensor according to comparative examples;
FIG. 10 is a graph showing a spectrum of light transmitted through a color filter array of an image sensor according to an example embodiment;
FIGS. 11 and 12 are graphs showing a spectrum of light sensed by an image sensor according to example embodiments;
FIGS. 13A and 13B are cross-sectional views illustrating a schematic structure of an image sensor according to another example embodiment, respectively showing rows of different pixel arrangements;
FIGS. 14A and 14B are cross-sectional views illustrating a schematic structure of an image sensor according to another example embodiment, respectively showing rows of different pixel arrangements;
FIGS. 15A and 15B are cross-sectional views illustrating a schematic structure of an image sensor according to another example embodiment, respectively showing rows of different pixel arrangements;
FIG. 16 is a plan view illustrating a shape and arrangement of nanoposts constituting a color separation lens array of the image sensor of FIGS. 15A and 15B;
FIGS. 17A and 17B are cross-sectional views illustrating a schematic structure of an image sensor according to another example embodiment, respectively showing rows of different pixel arrangements;
FIG. 18 is a plan view illustrating a shape of a pattern structure constituting a color separation lens array of the image sensor of FIGS. 17A and 17B;
FIG. 19 is a plan view illustrating a color arrangement by a pixel array of an image sensor according to another example embodiment;
FIG. 20 is a plan view illustrating a structure of a color filter array provided in the image sensor of FIG. 19;
FIG. 21 is a plan view illustrating a structure of a sensor substrate provided in the image sensor of FIG. 19;
FIGS. 22 and 23 are plan views respectively showing shapes of a color filter array and a sensor substrate provided in an image sensor according to another example embodiment;
FIG. 24 is a block diagram schematically illustrating an electronic device including an image sensor according to an example embodiment; and
FIG. 25 is a block diagram schematically illustrating a camera module included in the electronic device shown in FIG. 24.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one of the associated listed items. Expressions such as "at least one of," when preceding a list of elements, modify the entire list of elements and do not modify the individual elements of the list.

Hereinafter, example embodiments will be described with reference to the accompanying drawings. The example embodiments described herein are for illustrative purposes only, and various modifications may be made therein. In the drawings, like reference numerals refer to like elements, and the sizes of elements may be exaggerated for clarity of illustration.

In the following description, when an element is referred to as being "above" or "on" another element, it may be directly on the other element while making contact with the other element or may be above the other element without making contact with the other element.

Although the terms "first" and "second" are used to describe various elements, these terms are only used to distinguish one element from another element. These terms do not limit elements to having different materials or structures.

The terms of a singular form may include plural forms unless otherwise mentioned. It will be further understood that the terms "comprises" and/or "comprising" used herein specify the presence of stated features or elements, but do not preclude the presence or addition of one other features or elements.

In the present disclosure, terms such as "unit" or "module" may be used to denote a unit that has at least one function or operation and is implemented with hardware, software, or a combination of hardware and software.

An element referred to with the definite article or a demonstrative determiner may be construed as the element or the elements even though it has a singular form.

Operations of a method may be performed in appropriate order unless explicitly described in terms of order or described to the contrary. In addition, examples or exemplary terms (for example, "such as" and "etc.") are used for the purpose of description and are not intended to limit the scope of the inventive concept unless defined by the claims.

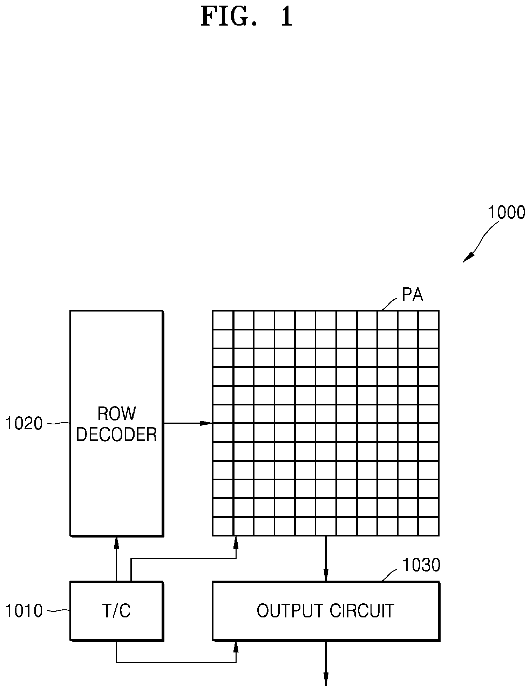

FIG. 1 is a block diagram schematically illustrating an image sensor 1000 according to an example embodiment.

Referring to FIG. 1, the image sensor 1000 may include a pixel array PA, a timing controller (T/C) 1010, a row decoder 1020, and an output circuit 1030. The image sensor 1000 may be a charge coupled device (CCD) image sensor or a complementary metal oxide semiconductor (CMOS) image sensor.

The pixel array PA includes pixels, which are two-dimensionally arranged in rows and columns. The row decoder 1020 selects one row of the pixel array PA based on a row address signal output from the timing controller 1010. For example, the row decoder 1020 selects one row of the pixel array PA in response to a row address signal output from the timing controller 1010. Light sensing signals from a plurality of pixels arranged in the selected row are output through the output circuit 1030 according to the columns. To this end, the output circuit 1030 may include a column decoder and an analog-to-digital converter (ADC). For example, the output circuit 1030 may include a plurality of ADCs arranged between the column decoder and the pixel array PA respectively for the columns, or may include one ADC arranged at an output terminal of the column decoder. The timing controller 1010, the row decoder 1020, and the output circuit 1030 may be provided as a single chip or as separate chips. According to an example embodiment, a processor for processing image signals output through the output circuit 1030 may be included in a single chip together with the timing controller 1010, the row decoder 1020, and the output circuit 1030.

The pixel array PA may include the pixels for sensing light having different wavelengths. The pixel array PA includes a color filter array including a plurality of filters filtering light of different wavelengths and a sensor substrate including a plurality of light sensing cells provided to face the plurality of filters, respectively. A color represented by a pixel may vary depending on an arrangement of the color filter array. Hereinafter, the expressions 'light sensing cell' and 'pixel' may be used interchangeably.

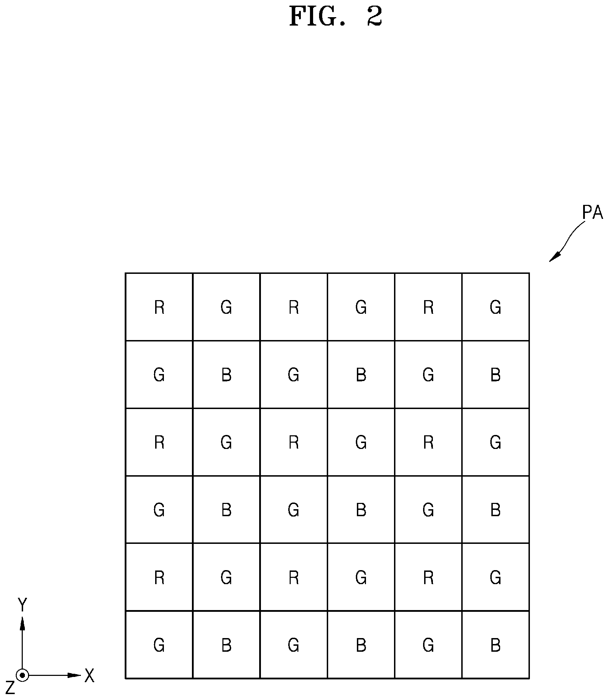

FIG. 2 is a plan view illustrating a color arrangement by the pixel array PA of the image sensor 1000 according to an example embodiment.

The color arrangement is a Bayer pattern arrangement generally employed in a general image sensor. As shown in FIG. 2, one unit pattern includes four quadrant regions, and first to fourth quadrants may respectively be a green pixel G, a red pixel R, a green pixel G, and a blue pixel B. The unit pattern is two-dimensionally repeated in a first direction (X direction) and a second direction (Y direction). In the overall color arrangement, in a first row, a plurality of red pixels R and a plurality of green pixels G are alternately arranged in the first direction (X direction), in a second row, a plurality of green pixels G and a plurality of blue pixels B are alternately arranged in the first direction (X direction), and the first and second rows are repeated in the second direction (Y direction).

The color arrangement shown in FIG. 2 is merely an example and is not limited thereto. For example, a CYGM arrangement in which a magenta pixel M, a cyan pixel C, a yellow pixel Y, and a green pixel G form one unit pattern, and an RGBW arrangement in which a green pixel G, a red pixel R, a blue pixel B, and a white pixel Wform one unit pattern may be used. In addition, the unit pattern may be implemented in a 3×2 array, and the color arrangement of the pixel array PA may be arranged in various ways according to the color characteristics of the image sensor 1000. Hereinafter, an example in which the pixel array PA of the image sensor 1000 has the Bayer pattern arrangement is described, but the main concept of the color filter array and the sensor substrate included in the pixel array PA may be applied to a color arrangement other than the Bayer pattern.

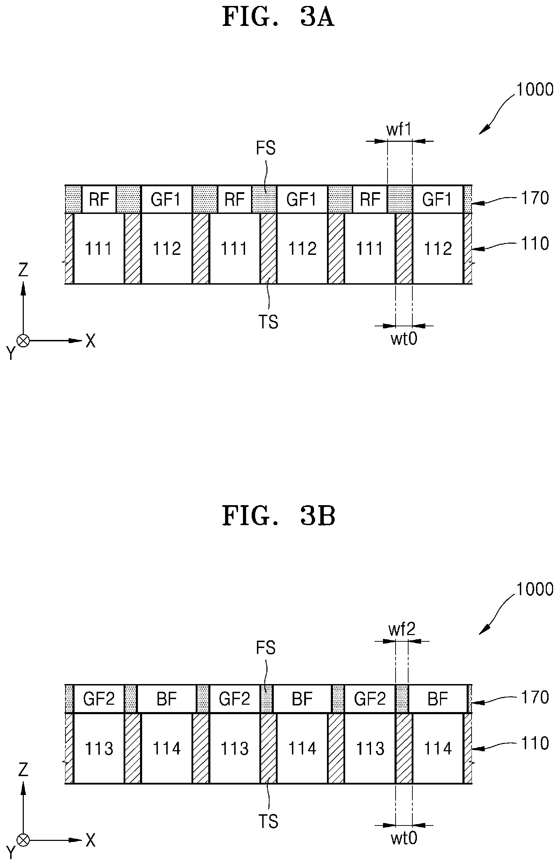

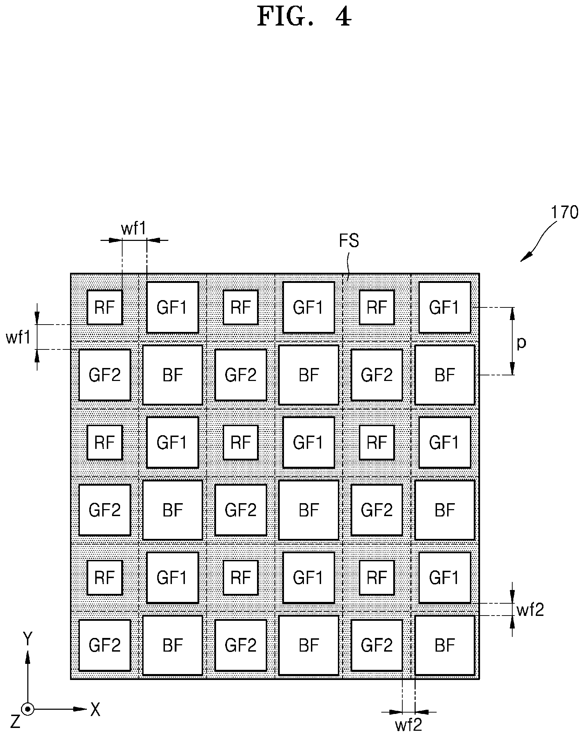

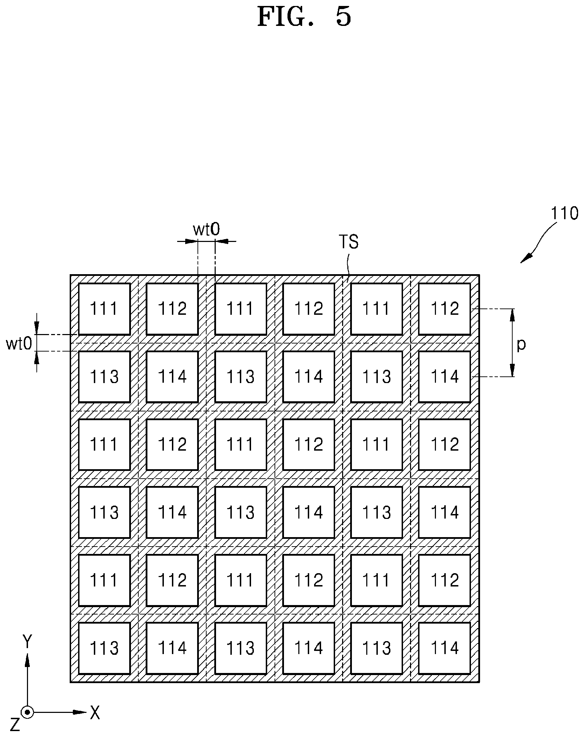

FIGS. 3A and 3B are cross-sectional views illustrating a schematic structure of the image sensor 1000 according to example embodiments, respectively showing different rows of different color arrangements. FIG. 4 is a plan view illustrating a structure of a color filter array 170 provided in the image sensor 1000 according to an example embodiment, and FIG. 5 is a plan view illustrating a structure of a sensor substrate 110 provided in the image sensor 1000 according to an example embodiment.

Referring to FIGS. 3A and 3B, the image sensor 1000 includes the sensor substrate 110 including a plurality of light sensing cells sensing light and a color filter array 170 provided on an upper portion of the sensor substrate 110. The color filter array 170 incudes a plurality of filters respectively facing the plurality of light sensing cells. For example, the color filter array 170 incudes a plurality of filters facing the plurality of light sensing cells in a one to one manner.

The color filter array 170 includes the plurality of filters filtering different colors. The color filter array 170 includes red filters RF, first green filters GF1, second green filters GF2, and blue filters BF arranged in the Bayer pattern, and the red filter RF, the first green filter GF1, the second green filter GF2, and the blue filter BF constitute a unit filter group. These unit filter groups are repeatedly arranged two-dimensionally in the first direction and the second direction. The color filter array 170 also includes a fence structure FS that separates the plurality of red filters RF, the first green filters GF1, the second green filters GF2, and the blue filters BF from each other.

The sensor substrate 110 includes a plurality of light sensing cells that convert light into electrical signals, and the plurality of light sensing cells include a red pixel 111, a first green pixel 112, a second green pixel 113, and a blue pixel 114 respectively facing the red filter RF, the first green filter GF1, the second green filter GF2, and the blue filter BF. The sensor substrate 110 may also include an isolation structure TS that separates the red pixel 111, the first green pixel 112, the second green pixel 113, and the blue pixel 114 from each other.

As illustrated in detail in FIG. 4, the fence structure FS may have a lattice form that separates the red filters RF, the green filters GF1 and GF2, and the blue filters BF from each other. The fence structure FS may include a material having a refractive index different than that of the plurality of filters provided in the color filter array 170. For example, the fence structure FS may include a material having a refractive index lower than that of the plurality of filters provided in the color filter array 170.

The red filters RF, the green filters GF1 and GF2, and the blue filters BF included in the color filter array 170 have different refractive indices, and thus the color filter array 170 has a pattern in which different refractive indices are distributed. Accordingly, in a position where different filters are adjacent to each other and exhibit a difference in refractive index, a path of light in a periphery of the position may be changed due to the difference in refractive index, and crosstalk may occur. Such crosstalk appears differently according to the difference in refractive index, that is, may appear differently according to types of adjacent filters, and also increases as a pixel size decreases. The image sensor 1000 according to an example embodiment includes the fence structure FS that separates adjacent filters from each other in the color filter array 170 in order to reduce such crosstalk.

The image sensor 1000 according to an example embodiment also sets a fence width of the fence structure FS that separates adjacent filters from each other in order to effectively reduce crosstalk. The width of the fence structure FS may be different according to types of two filters provided adjacent to each other with the fence structure FS interposed therebetween in the relevant location, and, for example, a plurality of different values may be applied according to locations.

Hereinafter, the width of the fence structure FS is a width at a location where different filters are adjacent to each other with the fence structure FS interposed the adjacent filters, and is defined as a width in two directions defining a two-dimensional arrangement of the color filter array 170. When the color filter array 170 has the two-dimensional arrangement in the first direction (X direction) and the second direction (Y direction), the width of the fence structure FS means a width in the first direction or a width in the second direction.

In the color filter array 170 of the Bayer pattern as shown, the width of the fence structure FS between the red filter RF and the first and second green filters GF1 and GF2 may be wf1, and width of the fence structure FS between the first and second green filters GF1 and GF2 and the blue filter BF may be wf2. According to an example embodiment, wf1 and wf2 may have different values. For example, because the refractive index of the red filter RF is higher than those of the green filters GF1 and GF2 and the blue filter BF, there is a large tendency of color shifting at a position adjacent to the red filter RF, and thus wf1 may be set greater than wf2.

According to an example embodiment, a difference between the maximum value and the minimum value among a plurality of values of the width of the fence structure FS may be equal to or greater than 20 nm, equal to or greater than 40 nm, equal to or greater than 50 nm, equal to or greater than 60 nm, or equal to or greater than 100 nm. This value may be appropriately determined in consideration of crosstalk reduction and light efficiency. The difference between the maximum value and the minimum value may be set with respect to a pixel pitch p. The pixel pitch p is defined as an arrangement period of filters. According to an example embodiment, the pixel pitch p is a distance between centers of two pixels (or filters) adjacent to each other in the first direction or the second direction. In the image sensor 1000 of an example embodiment, the pixel pitch p may be equal to or less than 1 µm, equal to or less than 0.8 µm, equal to or less than 0.6 µm, or equal to or less than 0.4 µm. A difference between the two widths wf1 and wf2 of the fence structure FS may be, for example, equal to or greater than 5%, equal to or greater than 10%, equal to or greater than 15%, or equal to or greater than 30%, of the pixel pitch p. Although it has been described that the width of the fence structure FS appears as one of two values of wf1 and wf2, according to the color arrangement or a relative location in the image sensor 1000, the width of the fence structure FS may be set to have three values.

The fence structure FS may have approximately two or more widths between 20 nm and 200 nm, or between 50 nm and 200 nm. A width range of the fence structure FS may be, for example, equal to or greater than 5% and less than 40%, or equal to or greater than 10% and less than 30% of the pixel pitch p.

According to the width of the fence structure FS, areas of cross-sections where the red filter RF, the first green filter GF1, the second green filter GF2, and the blue filter BF filter light also appear differently. The first green filter GF1 and the second green filter GF2 may have the same area that may be smaller than the area of the blue filter BF and larger than the area of the red filter RF.

The area of the filter may be set in consideration of the width of the fence structure FS for each location of capable of reducing crosstalk and light efficiency in consideration of the refractive index of each filter. For example, an area ratio occupied by the filter in a cell in which length of both sides is defined by a pixel pitch may be different according to a color to be filtered. A ratio of the area of the red filter RF to the area of one cell may be 30% to 70%, a ratio of the areas of the first green filter GF1 and the second green filter GF2 may be 40% to 80%, and a ratio of the area of the blue filter BF may be 70% to 90%.

As illustrated in detail in FIG. 5, the isolation structure TS provided on the sensor substrate 110 may also have a lattice form that separates the plurality of pixels 111 to 114 from each other. In the illustrated two-dimensional arrangement, a width of the isolation structure TS is defined as a width in the first direction (X direction) or a width in the second direction (Y direction), like the width of the fence structure FS. The isolation structure TS is used to prevent light passing through the filters RF, GF1, GF2, and BF respectively facing the plurality of pixels 111, 112, 113, and 114 from being incident to adjacent pixels other than the relevant pixel, and may include an insulating material. The plurality of pixels 111, 112, 113, 114 and the isolation structure TS may be formed by forming a deep trench insulator (DTI) having a predetermined pattern on a semiconductor material layer capable of converting light into an electrical signal.

The inside of the plurality of pixels 111, 112, 113, and 114 sensing light may have a structure like a waveguide by the isolation structure TS, and when the pixel size decreases, waveguide coupling may partially occur between adjacent pixels according to colors which each of the pixels 111, 112, 113, and 114 is responsible for. To reduce crosstalk due to this, the width of the isolation structure TS may be adjusted, that is, a line width of the waveguide may be adjusted, thereby preventing the occurrence of a mode in which light of a long wavelength is coupled to adjacent pixels.

The isolation structure TS may have the same width wt0 in the first direction and the width in the second direction. wt0 may be set to a value in the range of 20 nm to 200 nm or 50 nm to 150 nm. Alternatively, wt0 may be set to a value in the range of 5% to 50% or 10% to 30%, of the pixel pitch p.

The fence structure FS of the color filter array 170 and the isolation structure TS of the sensor substrate 110 may be vertically connected to each other.

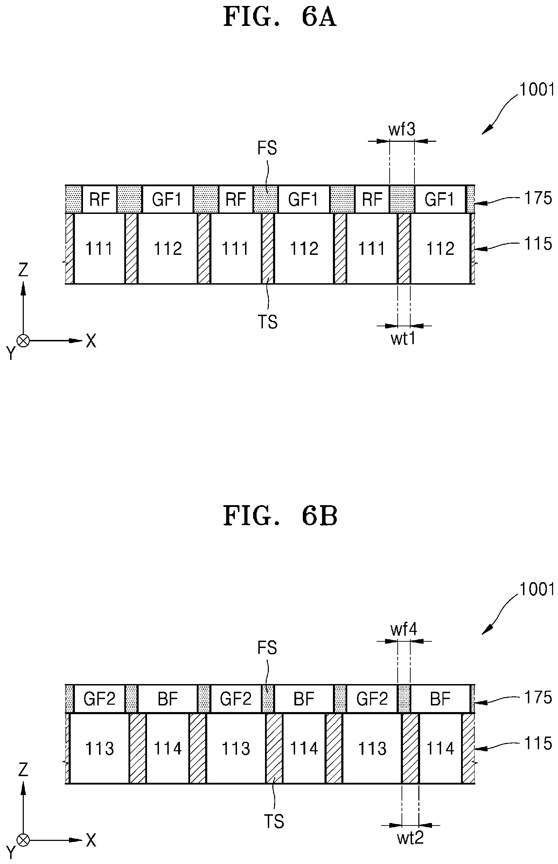

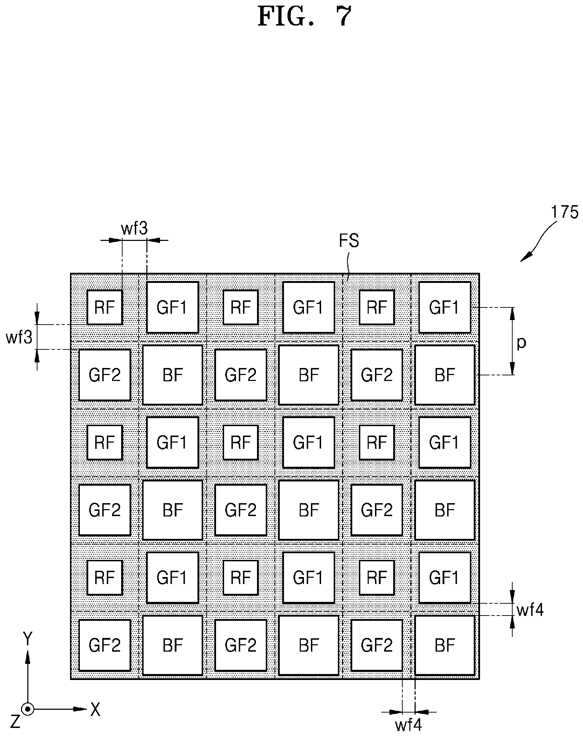

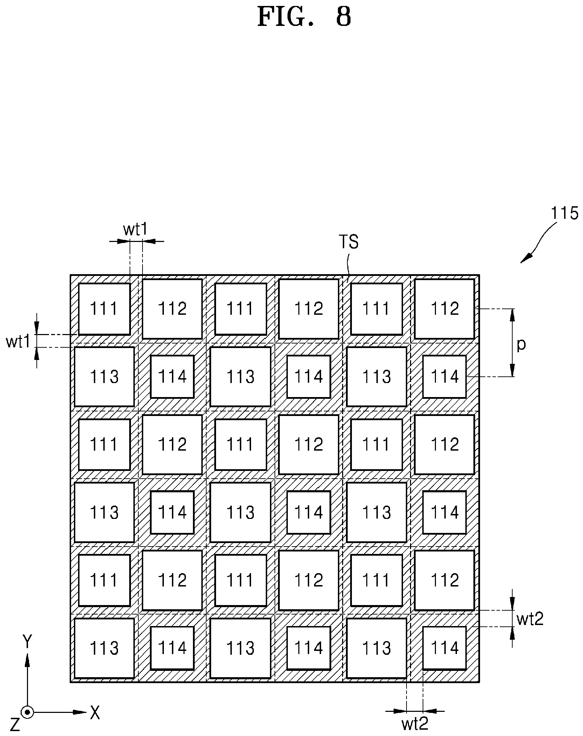

FIGS. 6A and 6B are cross-sectional views illustrating a schematic structure of an image sensor 1001 according to another example embodiment, respectively showing rows of different pixel arrangements. FIG. 7 is a plan view illustrating a structure of a color filter array 175 of the image sensor 1001 of FIGS. 6A and 6B, and FIG. 8 is a plan view showing a structure of a sensor substrate 115 of the image sensor 1001 of FIGS. 6A and 6B.

Referring to FIGS. 6A and 6B, in the image sensor 1001 of the example embodiment, both a width of the fence structure FS of the color filter array 175 and a width of the isolation structure TS of the sensor substrate 115 may be differently set according to types of adjacent filters, and types of filters facing adjacent pixels.

In the color filter array 175 of a Bayer pattern as shown in FIG. 7, the width of the fence structure FS between the red filter RF and the first and second green filters GF1 and GF2 may be wf3, and the width of the fence structure FS between the first and second green filters GF1 and GF2 and the blue filter BF may be wf4, and wf3 and wf4 may have different values. According to an example embodiment, wf3 may have a greater value than that of wf4. According to an example embodiment,wf3 and wf4 may be the same as or different from wf1 and wf2 described with reference to FIG. 4 which is the image sensor 1000 according to the above-described example embodiment. In the image sensor 1001 of the example embodiment, because the isolation structure TS of the sensor substrate 115 has two values of wt1 and wt2, the widths wf3 and wf4 of the fence structure FS of the color filter array 175 may be appropriately determined in relation to specific values of wt1 and wt2.

A difference between the two widths wf3 and wf4 of the fence structure FS may be equal to or greater than 20 nm, equal to or greater than 40 nm, equal to or greater than 50 nm, equal to or greater than 60 nm, or equal to or greater than 100 nm. The difference may be equal to or greater than 5% of the pixel pitch p, equal to or greater than 10%, equal to or greater than 15%, or equal to or greater than 30%. The pixel pitch p may be equal to or less than 1 µm, equal to or less than 0.8 µm, equal to or less than 0.6 µm, or equal to or less than 0.4 µm.

The fence structure FS may have approximately two or more widths between 20 nm and 200 nm. A width range of the fence structure FS may be, for example, equal to or greater than 5% of the pixel pitch p and less than 40%, or equal to or greater than 10% and less than 30%, of the pixel pitch p.

The width wf3 of the fence structure FS between the red filter RF and the first and second green filters GF1 and GF2 is greater than the width wf4 of the fence structure FS between the first and second green filters GF1 and GF2 and the blue filter BF, and thus areas of cross-sections where the red filter RF, the first green filter GF1, the second green filter GF2, and the blue filter BF filter light also appear differently. The first green filter GF1 and the second green filter GF2 may have the same area that may be smaller than the area of the blue filter BF and larger than the area of the red filter RF. For example, a ratio of the area of the red filter RF to the area of one cell in which the length of one side is the pixel pitch p may be 30% to 70%, a ratio of the areas of the first green filter GF1 and the second green filter GF2 may be 40% to 80%, and a ratio of the area of the blue filter BF may be 70% to 90%.

As illustrated in detail in FIG. 8, the isolation structure TS provided on the sensor substrate 115 may also have a lattice form that separates the plurality of pixels 111 to 114 from each other. In the illustrated two-dimensional arrangement, a width of the isolation structure TS is defined as a width in the first direction (X direction) or a width in the second direction (Y direction), like the width of the fence structure FS. In the example embodiment of FIG. 8, widths in the first direction and the second direction between the red pixel 111 and the first and second green pixels 112 and 113 may be wt1, and widths in the first direction and the second direction between the first and second green pixels 112 and 113 and the blue pixel 114 may be wt2. According to an example embodiment, wt1 and wt2 may have different values. wt2 may have a greater value than wt1. However, the disclosure is not limited thereto.

As described above, adjusting the width of the isolation structure TS reduces the occurrence of a mode in which light is coupled to adjacent pixels by considering the inside of the plurality of pixels 111, 112, 113, and 114 as a structure like a waveguide. In the example embodiment, more effective waveguide mode control and crosstalk reduction are possible by additionally applying the different widths wt1 and wt2 according to colors for which the pixels 111, 112, 113 and 114 are responsible.

According to an example embodiment, a difference between the two widths wt1 and wt2 of the fence structure FS may be equal to or greater than 20 nm, equal to or greater than 40 nm, equal to or greater than 50 nm, or equal to or greater than 100 nm. The difference may be equal to or greater than 5%, equal to or greater than 10%, equal to or greater than 15%, or equal to or greater than 30%, of the pixel pitch p.

The isolation structure TS may approximately have two or more widths between 40 nm and 200 nm, or between 50 nm and 150 nm. The widths wt1 and wt2 of the isolation structure TS may be set, for example, to values in the range of 10% to 40%, or 15% to 35%, of the pixel pitch p.

The width wt1 of the isolation structure TS between the red pixel 111 and the first and second green filters GF1 and GF2 may be less than the width wt2 of the isolation structure TS between the first and second green pixels 112 and 113 and the blue pixel 114, and accordingly, areas of cross-sections where the red pixel 111, the first green pixel 112, the second green pixel 113, and the blue pixel 114 filter light may also appear differently. The first green pixel 112 and the second green pixel 113 have the same area that may be larger than the area of the red pixel 111, and the red pixel 111 may have a larger area than that of the blue pixel 114. For example, a ratio of the area of the red pixel 111 to the area of one cell in which the length of both sides is the pixel pitch p may be 30% to 90%, a ratio of the areas of the first green pixel 112 and the second green pixel 113 may be 40% to 95%, and a ratio of the area of the blue pixel 114 may be 50 to 80%.

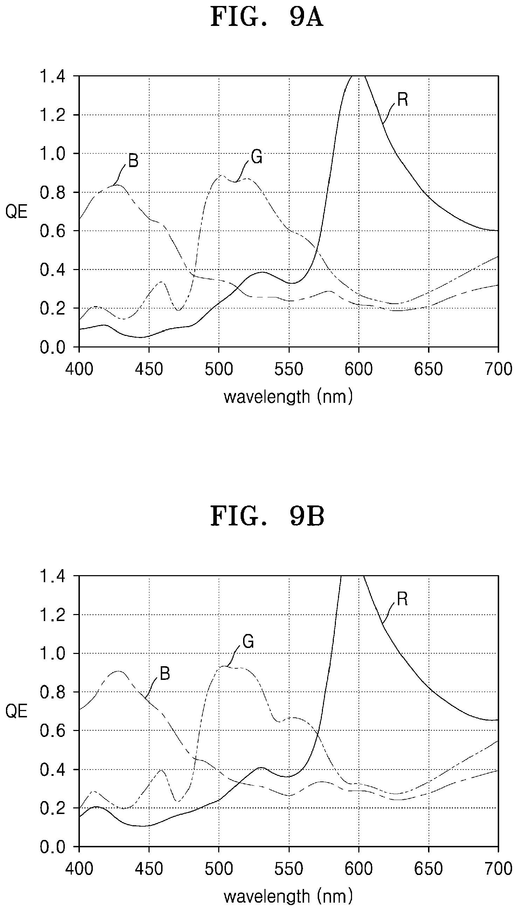

FIGS. 9A and 9B are graphs illustrating a spectrum of light transmitted through a color filter array of an image sensor according to two comparative examples.

The image sensor according to the comparative examples is different from the image sensor according to example embodiments in that the color filter array has an isolation structure with a constant width.

FIG. 9A illustrates a transmission spectrum of the color filter array of comparative example 1 in which a pixel pitch is 0.4 µm, a width of the isolation structure is constant as 100 nm, and cross-sectional lengths of a plurality of filters are all the same as 300 nm.

Referring to the graph in FIG. 9B, coupling to a red filter strongly occurs, and transmission characteristics appear as if a red light signal is increased.

FIG. 9B illustrates a transmission spectrum by the color filter array of comparative example 2 in a case where a pixel pitch is 0.4 µm, a width of an isolation structure is constant at 140 nm, and cross-sectional lengths of the filters are all the same at 260 nm.

FIG. 9B illustrates a case in which the width of the isolation structure is increased to 140 nm in order to reduce crosstalk. As shown in the graph, crosstalk is reduced compared to FIG. 9A, but it may be seen that as a ratio of the width of the isolation structure increases, that is, as a cross-sectional area of a filter filtering light decreases, an offset level increases.

In general, in order to maintain overall optical characteristics as a pixel is miniaturized, a volume ratio occupied by the isolation structure in a color filter tends to decrease in proportion to a high pixel. In other words, as the pixel becomes smaller, it is common to change the width of the isolation structure in a similar manner of change from comparative example 1 to comparative example 2. As shown in FIGS. 9A and 9B, according to this trend, the isolation performance may be insufficient or rather deteriorated. In consideration of this, the example embodiments propose applying a different width to the isolation structure for each pixel.

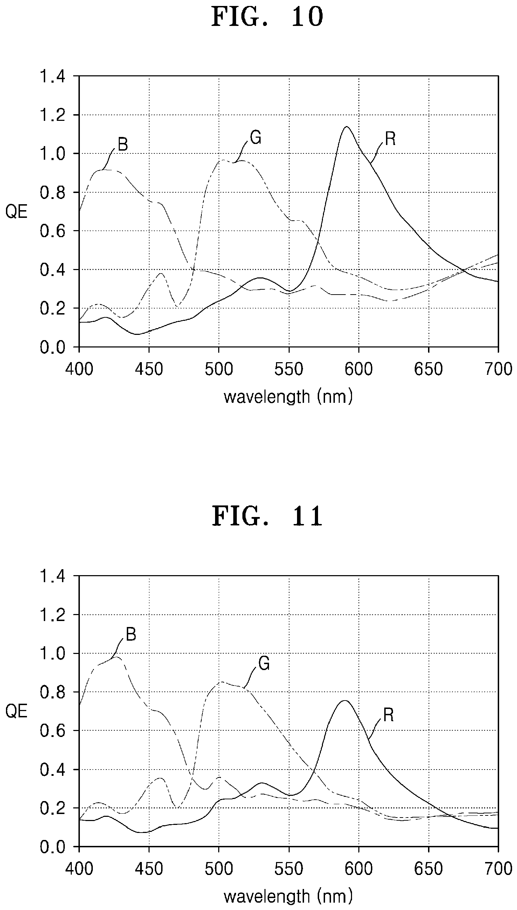

FIG. 10 is a graph showing a spectrum of light transmitted through a color filter array of an image sensor according to an example embodiment.

The transmission spectrum of FIG. 10 relates to a case where a pixel pitch is 0.4 µm, wf1 is 140 nm, and wf2 is 80 nm. That is, a width of the fence structure FS located between the red filter RF and the first green filter GF1 and between the red filter RF and the second green filter GF2 is 140 nm, a width of the fence structure FS located between the blue filter BF and the first green filter GF1 and between the blue filter BF and the second green filter GF2 is 80 nm, a cross-sectional length of the red filter RF is 220 nm, a cross-sectional length of each of the second green filters GF1 and GF2 is 300 nm, and a cross-sectional length of the blue filter BF is 340 nm.

When the graph of FIG. 10 is compared with the graph of FIGS. 9A and 9B, it may be seen that crosstalk is reduced and the offset level is also reduced by the color filter array 170 having the fence structure FS of which width is adjusted for each pixel.

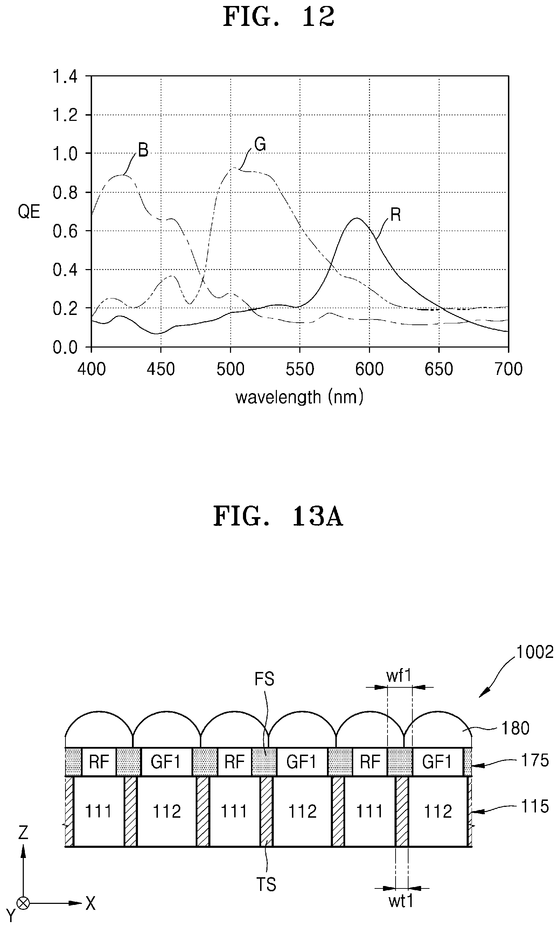

FIGS. 11 and 12 are graphs showing a spectrum of light by the image sensor 1000 according to example embodiments.

FIG. 11 is a graph showing a signal obtained by sensing light of the spectrum as shown in FIG. 10 in a sensor substrate in which a width of an isolation structure is constant at 100 nm. In other words, the graph of FIG. 11 corresponds to the signal sensed by the image sensor 1000 in the case where the pixel pitch p is 0.4 µm, wf1 and wf2 shown in FIG. 4 are 140 nm and 100 nm, respectively, and wt0 shown in FIG. 5 is 100 nm.

FIG. 12 is a graph showing a signal obtained by sensing light of the spectrum as shown in FIG. 10 in a sensor substrate in which the width of the isolation structure is not constant but is set such that cross-sectional lengths of a red pixel, a green pixel, and a blue pixel are 300 nm, 340 nm, and 260 nm, respectively. In other words, the graph of FIG. 12 corresponds to the signal sensed by the image sensor 1001 in the case where wf3 and wf4 shown in FIG. 7 are 140 nm and 100 nm, respectively, and wt1 and wt2 shown in FIG. 8 are 80 nm and 100 nm, respectively.

Upon comparing FIGS. 11 and 12, the offset signal is low in the case of FIG. 12, and it may be seen from this that crosstalk between adjacent cells is lower when the width of the isolation structure of the sensor substrate as well as the color filter array is adjusted for each pixel.

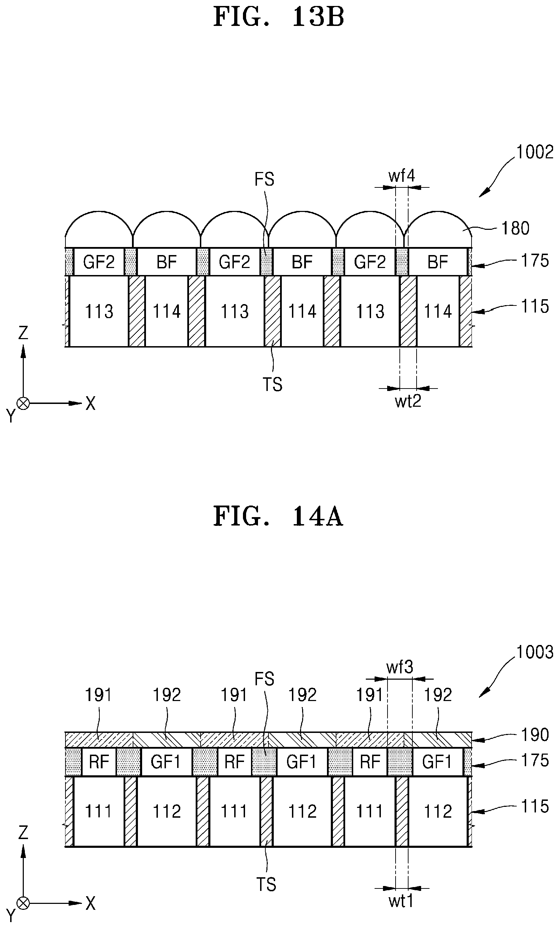

FIGS. 13A and 13B are cross-sectional views illustrating a schematic structure of an image sensor 1002 according to another example embodiment, respectively showing rows of different pixel arrangements.

The image sensor 1002 according to the example embodiment is different from the image sensor 1001 shown in FIGS. 6A and 6B in that a micro lens array 180 is further provided on the color filter array 175, and the remaining configuration is substantially the same.

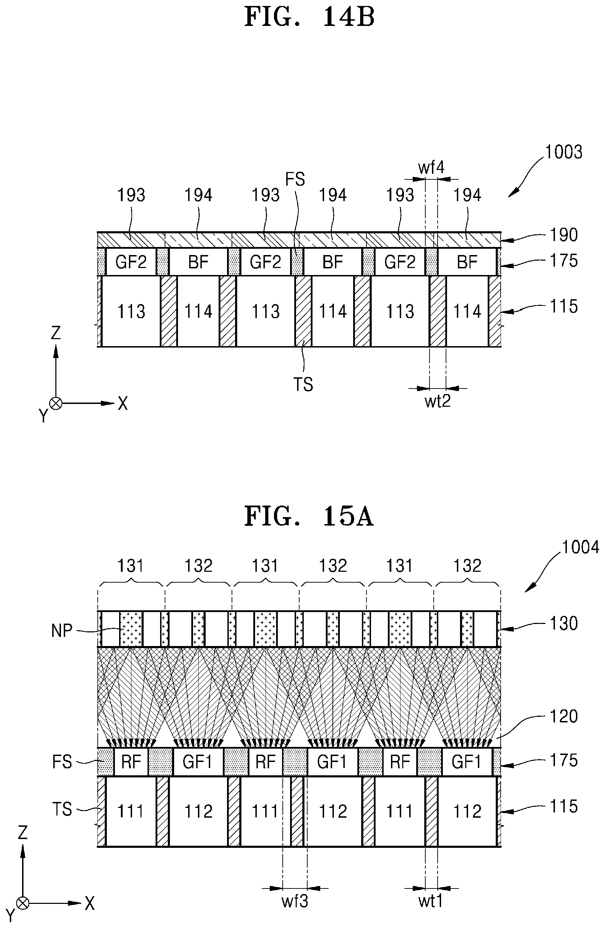

FIGS. 14A and 14B are cross-sectional views illustrating a schematic structure of an image sensor 1003 according to another example embodiment, respectively showing rows of different pixel arrangements.

The image sensor 1003 according to the example embodiment is different from the image sensor 1001 shown in FIGS. 6A and 6B in that a meta lens array 190 is further provided on the color filter array 175, and the remaining configuration is substantially the same.

The meta lens array 190 may include a first meta lens 191, a second meta lens 192, a third meta lens 193, and a fourth meta lens 194 respectively facing the red filter RF, the first green filter GF1, the second green filter GF2, and the blue filter BF. The first meta lens 191, the second meta lens 192, the third meta lens 193, and the fourth meta lens 194 each include a plurality of nanostructures having a shape dimension of a sub-wavelength, and shapes and arrangements of the nanostructures are set so as to exhibit optimized lens performance with respect to red light, green light, green light, and blue light, respectively. The shapes and arrangements of the nanostructures may be set such that each of the first meta lens 191, the second meta lens 192, the third meta lens 193, and the fourth meta lens 194 has an appropriate effective diameter and focal length, in order to minimize crosstalk that occurs while light condensed toward each of the red filter RF, the first green filter GF1, the second green filter GF2, and the blue filter BF passes through the color filter array 175. For example, compared to using the micro lens array 180 as shown in FIGS. 13A and 13B, it may be possible to to adjust various optical performance as well as have a thin structure , by using such a meta lens array 190.

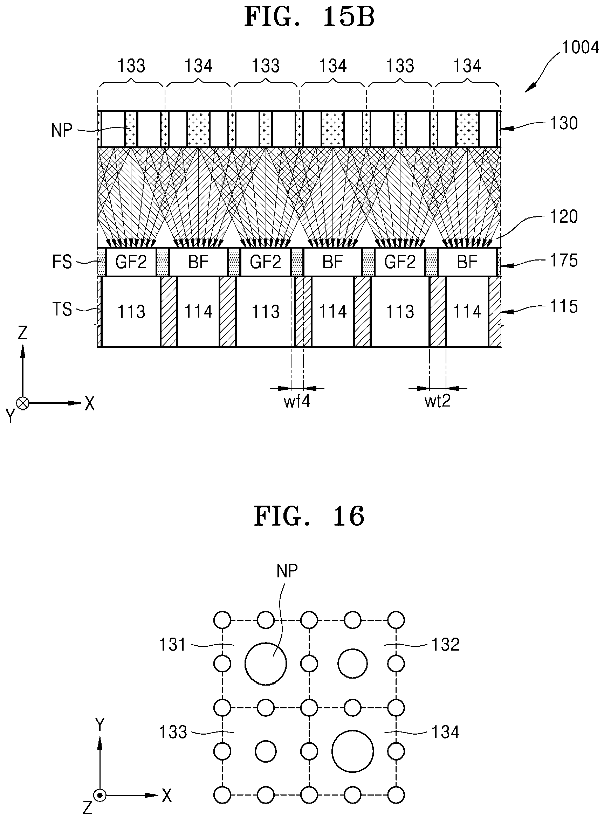

FIGS. 15A and 15B are cross-sectional views illustrating a schematic structure of an image sensor 1004 according to another example embodiment, respectively showing rows of different pixel arrangements. FIG. 16 is a plan view illustrating a shape and arrangement of nanoposts constituting a color separation lens array 130 of the image sensor 1004 of FIGS. 15A and 15B.

The image sensor 1004 of the example embodiment is different from the image sensor 1001 of FIGS. 6A and 6B in that a spacer layer 120 and the color separation lens array 130 are further provided on the color filter array 175, and the remaining configuration is substantially the same.

The color separation lens array 130 branches light incident thereon into separate colors, so that light of a corresponding color is incident on each of the red pixel 111, the first green pixel 112, the second green pixel 113, and the blue pixel 114. The color separation lens array 130 includes a first pixel corresponding region 131 facing the red pixel 111, a second pixel corresponding region 132 facing the first green pixel 112, a third pixel corresponding region 133 facing the second green pixel 113, and a fourth pixel corresponding region 134 facing the blue pixel 114. Each of the first to fourth pixel corresponding regions 131, 132, 133, and 134 includes one or more nanoposts NP, and the one or more nanoposts NP separate incident light for each wavelength to form a phase distribution for condensing light of different wavelength bands to the plurality of pixels 111, 112, 113, and 114.

The nanoposts NP of the first to fourth pixel corresponding regions 131, 132, 133 and 134 illustrated in FIG. 16 are an example for forming the above-described phase distribution, and may be modified into other shapes.

The spacer layer 120 is provided between the sensor substrate 110 and the color separation lens array 130 to maintain a constant distance between the sensor substrate 110 and the color separation lens array 130. The spacer layer 120 may include a dielectric material transparent to visible light, for example, SiO₂, silanol-based glass (such as siloxane-based SOG), etc., which has a refractive index lower than the refractive index of the nanoposts NP and low absorptivity in a visible light band. The thickness h of the spacer layer 120 may be within a range of ht - p ≤ h ≤ ht + p. Here, ht denotes a focal length of the color separation lens array 130 with respect to the center wavelength of a wavelength band in which the color separation lens array 130 splits light, and p denotes the pixel pitch. The thickness of the spacer layer 120 may be designed based on, for example, 540 nm, which is the central wavelength of green light.

According to an example embodiment, because the filter array 170 is provided between the sensor substrate 110 and the color separation lens array 130, the thickness of the spacer layer 120 may be set by considering the thickness of the color filter array 170 such that the thickness of the spacer layer 120 may be less than the focal length of the color separation lens array 130 with respect to the center wavelength of a wavelength band in which the color separation lens array 130 separates colors. For example, the thickness of the spacer layer 120 may be set to be less than the focal length of the color separation lens array 130 with respect to green light.

The spacer layer 120 may also support the first and second nanoposts NP of the color separation lens array 130. The spacer layer 120 may include a dielectric material having a refractive index less than those of the nanoposts NP.

Regions between the nanoposts NP may include a dielectric having a lower refractive index than that of the nanoposts NP, for example, air or SiO₂. According to an example embodiment, a protective layer of a low refractive index covering side surfaces and upper portions of the nanoposts NPs may be further provided.

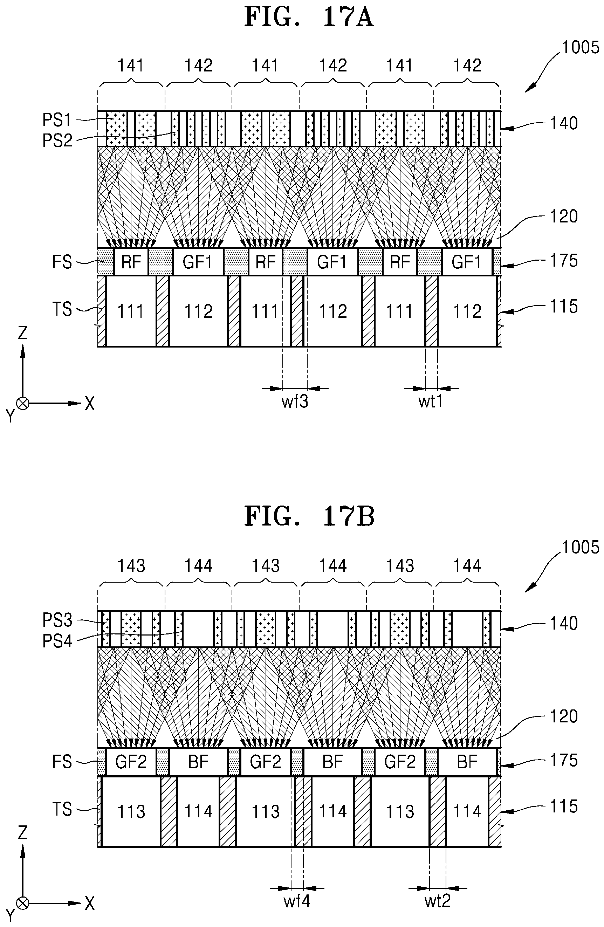

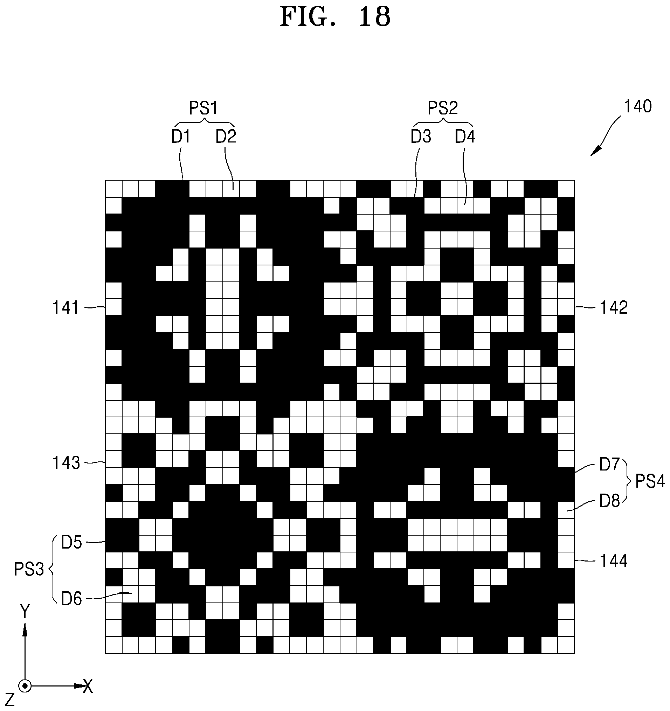

FIGS. 17A and 17B are cross-sectional views illustrating a schematic structure of an image sensor 1005 according to another example embodiment, respectively showing rows of different pixel arrangements. FIG. 18 is a plan view illustrating a shape of a pattern structure constituting a color separation lens array 140 of the image sensor 1005 of FIGS. 17A and 17B.

The image sensor 1005 of the example embodiment is different from the above-described image sensor 1004 of FIGS. 15A and 15B, in that, a detailed shape of the color separation lens array 140 is provided, and the remaining configuration is substantially the same.

Similarly to the color separation lens array 130 described above, the color separation lens array 140 branches light incident thereon for each color so that light of responsible color is incident on each of the red pixel 111, the first green pixel 112, the second green pixel 113, and the blue pixel 114. The color separation lens array 140 includes a first pixel corresponding region 141 facing the red pixel 111, a second pixel corresponding region 142 facing the first green pixel 112, a third pixel corresponding region 143 facing the second green pixel 113, and a fourth pixel corresponding region 144 facing the blue pixel 114.

In the first to fourth pixel corresponding regions 141, 142, 143, and 144, a first pattern structure PS1 of a first form, a second pattern structure PS2 of a second form, a third pattern structure PS3 of a third form, and a fourth pattern structure PS4 of a fourth form may be respectively formed so that the color separation lens array 140 separates incident light for each wavelength to form a phase distribution for condensing light of different wavelength bands to the plurality of pixels 111, 112, 113 and 114.

Referring to FIG. 18, the first pattern structure PS1 includes a first dielectric D1 having a first refractive index and formed in the first form, and a second dielectric D2 having a second refractive index less than the first refractive index and filled between the first dielectrics D1 of the first form. The first form is determined so that the first dielectric D1 is present in any vertical cross-section of the first pattern structure PS1, and is a freeform that is not particularly limited. Here, the vertical cross-section means a cross-section cut along a straight line on the XY plane.

Similarly, the second pattern structure PS2 includes a third dielectric D3 having a third refractive index and formed in the second form, and a fourth dielectric D4 having a fourth refractive index less than the third refractive index and filled gaps of the third dielectric D3 in the second form. The second form may be determined such that the third dielectric D3 is present in any vertical cross-section of the second pattern structure PS2.

Similarly, the third pattern structure PS3 also includes a fifth dielectric D5 having a fifth refractive index and formed in the third form and a sixth dielectric D6 having a sixth refractive index less than the fifth refractive index and filled gaps of the fifth dielectric D5 in the third form. The third form may be determined such that the fifth dielectric D5 is present in any vertical cross-section of the fourth pattern structure PS4.

Similarly, the fourth pattern structure PS4 also includes a seventh dielectric D5 having a seventh refractive index and formed in the fourth form, and an eighth dielectric D8 having an eighth refractive index less than the seventh refractive index and filled between the seventh dielectrics D7 of the fourth form. The fourth form may be determined such that the seventh dielectric D7 is present in any vertical cross-section of the fourth pattern structure PS4. The fourth pattern structure PS4 is rotated by 90 degrees with respect to the first pattern structure PS1.

The first dielectric D1, the third dielectric D3, the fifth dielectric D5, and the seventh dielectric D7 may all include the same material, and the second dielectric D2, the fourth dielectric D4, the sixth dielectric D6 and the eighth dielectric D8 may all include the same material. For example, the first dielectric D1, the third dielectric D3, the fifth dielectric D5, and the seventh dielectric D7 may include a dielectric material having a high refractive index and a low absorption in a visible light band, such as TiO₂, GaN, SiN₃, ZnS, ZnSe, Si₃N₄, etc. In addition, the second dielectric D2, the fourth dielectric D4, the sixth dielectric D6, and the eighth dielectric D8 may include, for example, a dielectric material having a low refractive index and low absorption in the visible light band, such as air, SiO₂, SOG, etc. For example, when the second dielectric D2, the fourth dielectric D4, the sixth dielectric D6, and the eighth dielectric D8 include air, the color separation lens array 140 may be easily manufactured, by etching the first dielectric D1, the third dielectric D3, the fifth dielectric D5, and the seventh dielectric D7 so as to have the form shown in FIG. 18.

In the image sensors 1004 and 1005 respectively including the color separation lens array 130 and 140, as described with reference to FIGS. 15A, 15B, 16, 17A, 17B and 18, because most of light incident on each of the plurality of filters RF, GF1, GF2, and BF of the color filter array 175 is light of the corresponding color, a decrease in light efficiency by the color filter array 175 hardly occurs. In addition, the color separation lens arrays 130 and 140 operate as if lenses having an effective diameter of several times the pixel pitch, for example, 1.2 times to 4 times, face a plurality of pixels, respectively, and are overlapped, thereby exhibiting high color separation efficiency. In addition, as described above, crosstalk such as color mixing with adjacent pixels may also be reduced by the fence structure FS having a width adjusted for each pixel provided in the color filter array 175 and the isolation structure TS having a width adjusted for each pixel provided in the sensor substrate 115.

In the above-described various example embodiments, it has been described that the width of the fence structure FS is adjusted for each pixel and the width of the isolation structure TS is constant or is adjusted for each pixel, but is not limited thereto. For example, an example embodiment in which the width of the fence structure TS is set to a constant and appropriate value and the width of the isolation structure TS is adjusted for each pixel may be possible.

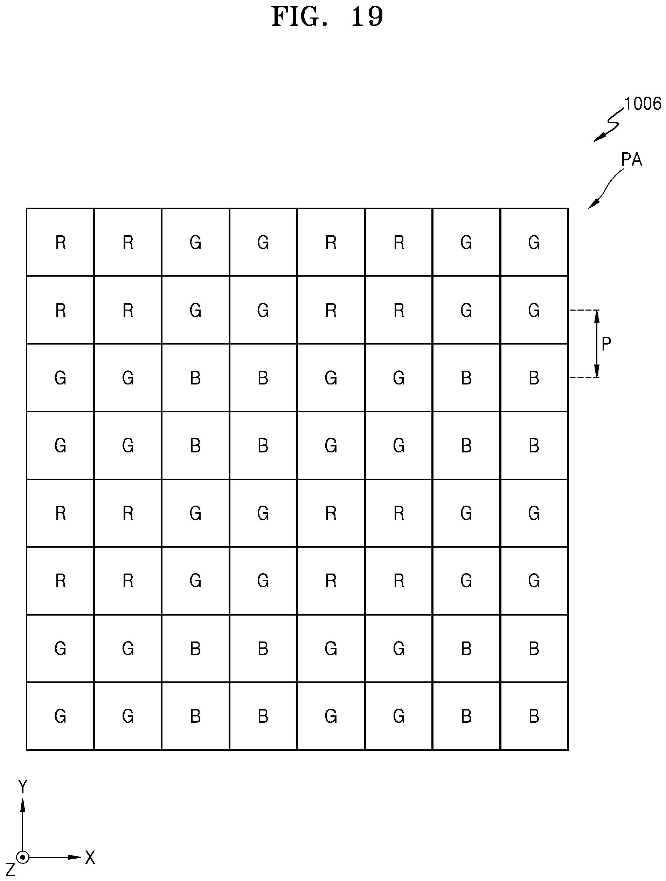

FIG. 19 is a plan view illustrating a color arrangement by a pixel array of an image sensor 1006 according to another example embodiment.

The pixel array PA of the image sensor 1006 may have a tetra-cell type arrangement. Such an arrangement may be used to improve the problem of a sensitivity decrease in low illuminance that occurs when the pixel pitch p is extremely small, such as 1 micron, or 0.6 micron. The same color may be expressed in a unit of 2x2 as shown, and a method of using 4 pixels together in low illuminance may be used.

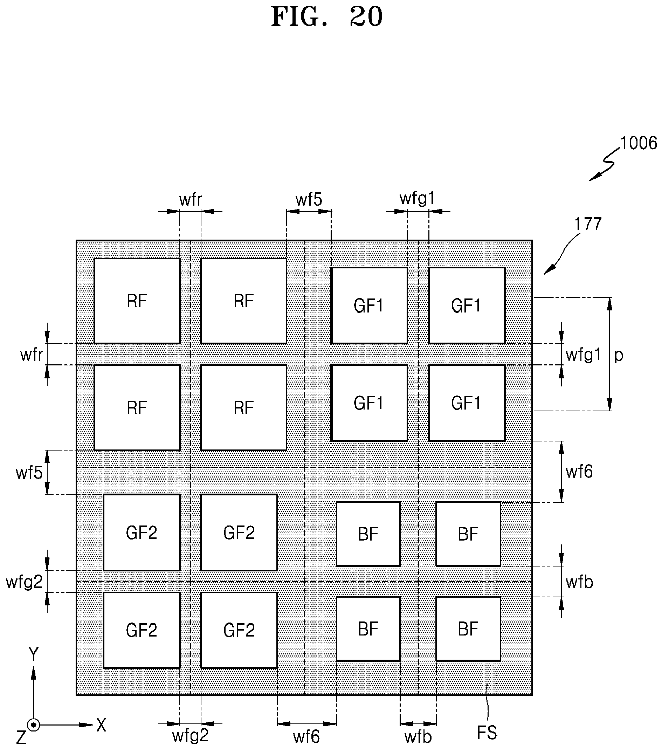

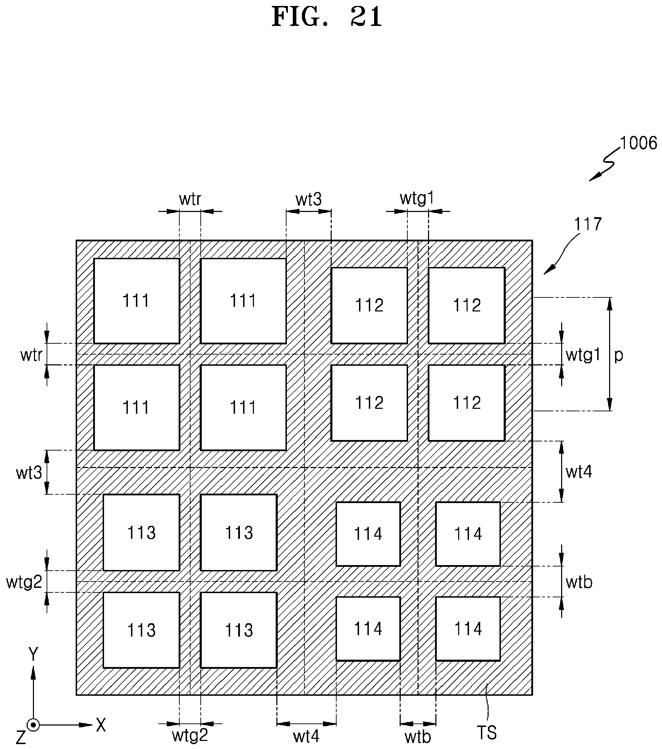

FIG. 20 is a plan view illustrating a structure of a color filter array 177 provided in the image sensor 1006 of FIG. 19, and FIG. 21 is a plan view illustrating a structure of a sensor substrate 117 provided in the image sensor 1006 of FIG. 19.

Referring to FIG. 20, a plurality of filters of the color filter array 177 include a red filter group including four red filters RF, a first green filter group including four first green filters GF1, a second green filter group including four second green filters GF2, and a blue filter group including four blue filters BF. These red filter group, first green filter group, second green filter group and the blue filter group may be arranged in the Bayer pattern.

The fence structure FS of the color filter array 177 may have three or more different types of widths.

The fence structure FS may have different widths between filters of the same color and between filters of different colors. For example, a width wfr of the fence structure FS between the adjacent red filters RF and a width wf5 of the fence structure FS between the adjacent red filter RF and the first green filter GF1 may be different from each other. In addition, a width wfg1 of the fence structure FS between the adjacent first green filters GF1 and a width wf6 of the fence structure FS between the first green filter GF1 and the blue filter BF which are adjacent to each other may be different from each other. In addition, a width wfb of the fence structure FS between the adjacent blue filters BF and a width wf6 of the fence structure FS between the adjacent blue filter BF and the second green filter GF2 which are adjacent to each other may be different from each other.

The fence structure FS may have different widths between filters of the same color in two or more filter groups. For example, the width wfr of the fence structure FS between the red filters RF, the width wfg1 of the fence structure FS between the first green filters GF1, and the width wfb of the fence structure FS between the blue filters BF may be different from each other. The width wfg1 of the fence structure between the first green filters GF1 and a width wfg2 of the fence structure FS between the second green filters GF2 may be the same.

In the fence structure FS, a width wf5 between the red filter RF and the first green filter GF1 which are adjacent to each other between the red filter group and the first green filter group may be different from a width wf6 between the first green filter GF1 and the blue filter BF which are adjacent to each other between the first green filter group and the blue filter group.

Areas of the illustrated filters are examples and are not limited to the illustrated forma. For example, similarly to the fence structure FS shown in FIG. 4, wf5 may be greater than wf6. A ratio of areas occupied by the filters in each cell repeatedly arranged may also be set in a relationship similar to that described with reference to FIG. 4. Here, the cell means a unit region formed by dividing the color filter array 177 by the number of filters. In the tetra-cell arrangement, the center of the filters provided in the cell does not coincide with the center of the cell and is somewhat deviated as shown, therefore, the pixel pitch p is defined as a distance between centers of adjacent cells other than a distance between centers of adjacent filters. The illustrated widths wf5, wf6, wfr, wfg1, wfg2, and wfb may be set as a ratio to the pixel pitch p, and, for example, may be set to be equal to or greater than 5% and less than 40%, or equal to or greater than 10% and less than 30%, of the pixel pitch p.

Referring to FIG. 21, the sensor substrate 117 includes light sensing cells respectively facing the filters of the color filter array 177 of FIG. 20.

The four red pixels 111 respectively face the four red filters RF of FIG. 20, the four first green pixels 112 respectively face the four first green filters GF1 of FIG. 20, the four second green pixels 113 respectively face the four second green filters GF2 of FIG. 20, and the four blue pixels 114 respectively face the four blue filters BF of FIG. 20.

The width of the isolation structure TS may be different for each location according to a type of a filter facing two pixels provided adjacent to each other with the width interposed therebetween. The isolation structure TS may have a plurality of types of widths, wtr, wtg1, wtg2, wtb, wt3, and wt4 as illustrated.

The width wtr of the isolation structure TS between the adjacent red pixels 111 and the width wt3 of the isolation structure TS between the red pixel 111 and the first green pixel 112 which are adjacent to each other may be different from each other. In addition, the width wtg1 of the isolation structure TS between the adjacent first green pixels 112 and the width wt4 of the isolation structure TS between the first green pixel 112 and the blue pixel 114 which are adjacent to each other may be different from each other. In addition, the width wfb of the isolation structure TS between the adjacent blue pixels BF and the width wt4 of the isolation structure TS between the blue pixel 114 and the second green pixel GF2 which are adjacent to each other may be different from each other.

Also, the width wtr of the isolation structure TS between the red pixels 111, the width wtg1 of the isolation structure TS between the first green pixels 112, and the width wtb of the isolation structure TS between the blue pixels 114 may be different from each other. The width wtg1 of the isolation structure TS between the first green pixels 112 and the width wtg2 of the isolation structure TS between the second green pixels 113 may be the same.

The width wt3 of the isolation structure TS between the red pixel 111 and the first green pixel 112 which are adjacent to each other may be different from the width wt4 of the isolation structure TS between the first green pixel 112 and the blue pixel 114 which are adjacent to each other. The width wt3 of the isolation structure TS between the red pixel 111 and the second green pixel 113 which are adjacent to each other may be different from the width wt4 of the isolation structure TS between the second green pixel 113 and the blue pixel 114 which are adjacent to each other.

Areas of the illustrated filters are examples and are not limited to the illustrated forms. For example, like the isolation structure TS illustrated in FIG. 5, all pixels may have the same area, or similarly to the isolation structure TS illustrated in FIG. 8, wt4 may be greater than wt3. A ratio of areas occupied by pixels in each cell repeatedly arranged may also be set in a relationship similar to that described with reference to FIG. 8.

The image sensor 1006 described in FIGS. 19 to 21 has been described in the tetra cell arrangement in which the pixels represent the same color in units of 2x2, but the pixel arrangement may be changed to a nona cell arrangement in which the pixels represent the same color in units of 3x3 and may also be changed to another similar pixel arrangement representing the same color in different number of units. That is, the pixel arrangement may be changed to a pixel arrangement in which the same colors are arranged in units of NxN (N is an integer greater than or equal to 2), and suitable for such an arrangement, the widths of the fence structure FS and the widths of the isolation structure TS located between the same colors and between different colors may be set.

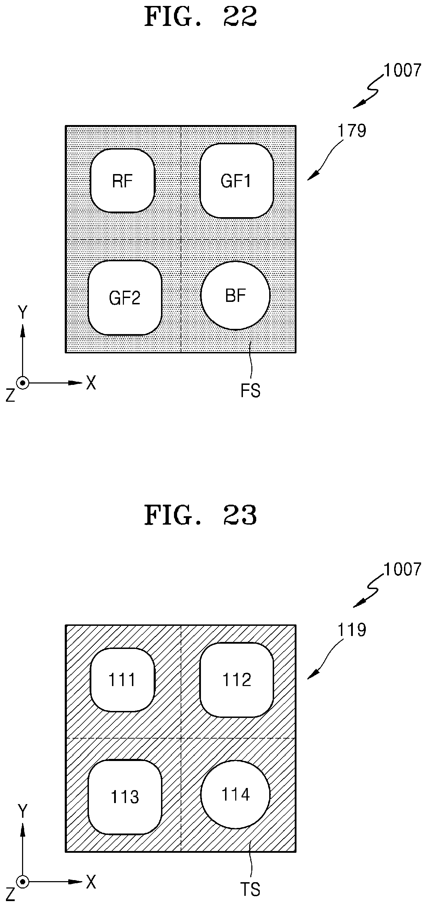

FIGS. 22 and 23 are plan views respectively showing shapes of a color filter array 179 and a sensor substrate 119 provided in an image sensor 1007 according to another example embodiment.

In the filters RF, GF1, GF2, and BF of the color filter array 179 provided in the image sensor 1007, a shape of a cross-section that is a light-incident surface, that is, a cross-section perpendicular to a Z-direction, is not limited to a rectangular shape as shown in the above-described example embodiments, and may have a circular shape, an oval shape, or a rectangular shape with rounded corners. The fence structure FS is located in the entire region between the filters RF, GF1, GF2, and BF, in other words, the cross-section of the fence structure FS also has a shape corresponding to reverse shapes of the filters RF, GF1, GF2, and BF.

In the pixels 111, 112, 113, and 114 of the sensor substrate 119 of the image sensor 1007, a shape of a cross-section that is the light-incident surface, that is, the cross-section perpendicular to the Z-direction, may have a circular shape, an oval shape, or a rectangular shape with rounded corners. Similarly, the cross-sectional shape of the isolation structure TS also corresponds to reverse shapes of the pixels 111, 112, 113 and 114.

Such a shape is due to an etching process of forming the fence structure FS and the isolation structure TS, the shapes of the filters RF, GF1, GF2, and BF in the color filter array 179 may be slightly different according to locations, and the shapes of the pixels 111, 112, 113, and 114 in the sensor substrate 119 may also be slightly different according to locations.

In FIGS. 22 and 23, the rectangular and circular shapes with rounded corners are illustrated as being applied to the color filter array 179 and the sensor substrate 119, but are not limited to the illustrated shapes and locations, and may all have similar shapes, or may have other various forms according to locations.

Similarly to the image sensors 1002, 1003, 1004, and 1004 described above, the micro lens array 180, the meta lens array 190, or the color separation lens arrays 130 and 140 may be further provided in the image sensors 1005 and 1006 described with reference to FIGS. 19 to 23.

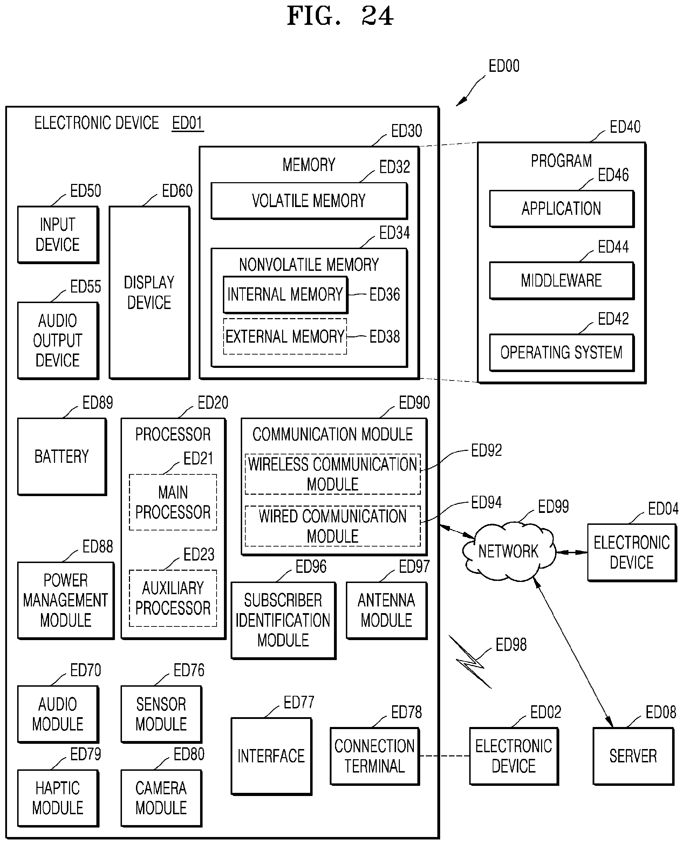

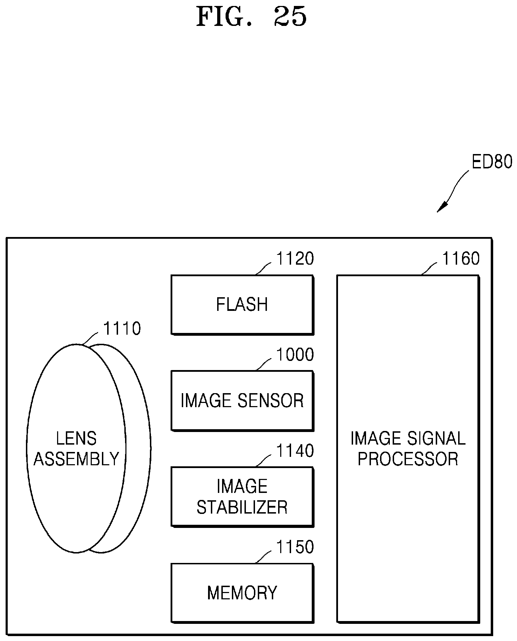

FIG. 24 is a block diagram schematically illustrating an electronic device ED01 including an image sensor according to an example embodiment, and FIG. 25 is a block diagram schematically illustrating a camera module ED 80 included in the electronic device ED01 shown in FIG. 24.

FIG. 24 illustrates, as an example, the electronic device ED01 including an image sensor 1000. Referring to FIG. 24, in a network environment ED00, the electronic device ED01 may communicate with another electronic device ED02 through a first network ED98 (a near-field wireless communication network or the like) or may communicate with another electronic device ED04 and/or a server ED08 through a second network ED99 (a far-field wireless communication network, etc.) The electronic device ED01 may communicate with the electronic device ED04 through the server ED08. The electronic device ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. Some (the display device ED60, etc.) of the components may be omitted from the electronic device ED01, or other components may be added to the electronic device ED01. Some of the components may be implemented in one integrated circuit. For example, the sensor module ED76 (a fingerprint sensor, an iris sensor, an illuminance sensor, etc.) may be embedded in the display device ED76 (a display or the like).

The processor ED20 may execute software (a program ED40 or the like) to control one other components (hardware or software components, etc.) of the electronic device ED01 connected to the processor ED20, and may perform a variety of data processing or operations. As a part of the data processing or operations, the processor ED20 may load instructions and/or data received from other components (the sensor module ED76, the communication module ED90, etc.) into a volatile memory ED32, process the instructions and/or data stored in the volatile memory ED32, and store result data in a nonvolatile memory ED34. According to an example embodiment, the nonvolatile memory ED34 may include an internal memory ED36 and/or an external memory ED38. The processor ED20 may include a main processor ED21 (a center processing unit, an application processor, or the like) and an auxiliary processor ED23 (a GPU, an image signal processor, a sensor hub processor, a communication processor, etc.), which is operated independently or together with the main processor ED21. The auxiliary processor ED23 may consume less power than the main processor ED21 and may perform specialized functions.

The auxiliary processor ED23 may control functions and/or states related to some (the display device ED60, the sensor module ED76, the communication module ED90, etc.) of the components of the electronic device ED01 on behalf of the main processor ED21 while the main processor ED21 is in an inactive (e.g., sleep) state or together with the main processor ED21 while the main processor ED21 is in an active (e.g., application execution) state. The auxiliary processor ED23 (an image signal processor, a communication processor etc.) may be implemented as a portion of other functionally relevant components (the camera module ED80, the communication module ED90, etc.)

The memory ED30 may store a variety of data required by the components (the processor ED20, the sensor module ED76, etc.) of the electronic device ED01. The data may include, for example, software (the program ED40, etc.) and input data and/or output data for commands related thereto. The memory ED30 may include the volatile memory ED32 and/or the nonvolatile memory ED34.

The program ED40 may be stored as software in the memory ED30, and may include an operating system ED42, middleware ED44, and/or an application ED46.

The input device ED50 may receive commands and/or data to be used for the components (the processor ED20, etc.) of the electronic device ED01 from the outside (a user, etc.) of the electronic device ED01. The input device ED50 may include a microphone, a mouse, a keyboard, and/or a digital pen (a stylus pen etc.)

The audio output device ED55 may output an audio signal to the outside of the electronic device ED01. The audio output device ED55 may include a speaker and/or a receiver. The speaker may be used for general purposes such as multimedia playback or record playback, and the receiver may be used to receive incoming calls. The receiver may be provided as a portion of the speaker or may be implemented as a separate device.

The display device ED60 may visually provide information to the outside of the electronic device ED01. The display device ED60 may include a display, a hologram device, or a projector, and a control circuit for controlling devices. The display device ED60 may include touch circuitry set to sense a touch, and/or sensor circuitry (a pressure sensor, etc.) configured to measure the intensity of force generated by the touch.

The audio module ED70 may convert sound into an electrical signal, and vice versa. The audio module ED70 may obtain sound through the input device ED50, or may output sound through the audio output device ED55 and/or speakers and/or headphones of another electronic device (the electronic device ED02 etc.) directly or wirelessly connected to the electronic device ED01.

The sensor module ED76 may detect an operating state (power, temperature, etc.) of the electronic device ED01 or an external environmental state (user status, etc.), and may generate an electrical signal and/or a data value corresponding to the detected state. The sensor module ED76 may include a gesture sensor, a gyro sensor, a barometric sensor, a magnetic sensor, an acceleration sensor, a grip sensor, a proximity sensor, a color sensor, an infrared (IR) sensor, a biological sensor, a temperature sensor, a humidity sensor, and/or an illuminance sensor.

The interface ED77 may support one designated protocols, which may be used to directly or wirelessly connect the electronic device ED01 with other electronic devices (the electronic device ED02, etc.) The interface ED77 may include a high definition multimedia interface (HDMI), a universal serial bus (USB) interface, a secure digital (SD) card interface, and/or an audio interface.

A connection terminal ED78 may include a connector through which the electronic device ED01 may be physically connected to other electronic devices (the electronic device ED02, etc.) The connection terminal ED78 may include an HDMI connector, a USB connector, an SD card connector, and/or an audio connector (a headphone connector, etc.)

The haptic module ED79 may convert an electrical signal into a mechanical stimulus (vibration, movement, etc.) or an electrical stimulus that a user may perceive through tactile sensation or kinesthesia. The haptic module ED79 may include a motor, a piezoelectric element, and/or an electric stimulation device.

The camera module ED80 may capture a still image and a moving image. The camera module ED80 may include a lens assembly having one lenses, the image sensor 1000 described with reference to FIG. 1, an image signal processor, and/or a flash. The image sensor 1000 may be the image sensor 1000 described with reference to FIGS. 1 to 5, any one of the various image sensors 1001, 1002, 1003, 1004, 1005, 1006, and 1007 according to other example embodiments, or an image sensor resulted from combining or modifying the image sensors 1001, 1002, 1003, 1004, 1005, 1006, and 1007. The lens assembly included in the camera module ED80 may collect light coming from an object to be imaged.

The power management module ED88 may manage power supplied to the electronic device ED01. The power management module ED88 may be implemented as a portion of a power management integrated circuit PMIC.

The battery ED89 may supply power to components of the electronic device ED01. The battery ED89 may include a non-rechargeable primary battery, a rechargeable secondary battery, and/or a fuel cell.

The communication module ED90 may support establishment of a direct (wired) communication channel and/or a wireless communication channel between the electronic device ED01 and other electronic devices (the electronic device ED02, the electronic device ED04, the server ED08, etc.), and communication through the established communication channel. The communication module ED90 operates independently of the processor ED20 (an application processor, etc.) and may include one communication processors supporting direct communication and/or wireless communication. The communication module ED90 may include a wireless communication module ED92 (a cellular communication module, a short-range wireless communication module, a global navigation satellite system (GNSS), etc.) and/or a wired communication module ED94 (a local region network (LAN) communication module, a power line communication module, etc.) A corresponding communication module from among these communication modules may communicate with other electronic devices through the first network ED98 (a local region network such as Bluetooth, WiFi Direct, or infrared data association (IrDA)) or the second network ED99 (a telecommunication network such as a cellular network, the Internet, or computer networks (LAN, WAN, etc.)). These various types of communication modules may be integrated into a single component (a single chip etc.) or may be implemented as a plurality of separate components (multiple chips). The wireless communication module ED92 may identify and authenticate the electronic device ED01 within a communication network such as the first network ED98 and/or the second network ED99 using subscriber information (an international mobile subscriber identifier (IMSI), etc.) stored in the subscriber identity module ED96.

The antenna module ED97 may transmit and/or receive signals and/or power to and/or from the outside (other electronic devices, etc.) An antenna may include a radiator made of a conductive pattern formed on a substrate (a PCB, etc.) The antenna module ED97 may include one such antennas. When a plurality of antennas are included in the antenna module ED97, the communication module ED90 may select an antenna suitable for a communication method used in a communication network, such as the first network ED98 and/or the second network ED99, among the plurality of antennas. Signals and/or power may be transmitted or received between the communication module ED90 and other electronic devices through the selected antenna. Other components (an RFIC, etc.) besides the antenna may be included as part of the antenna module ED97.

Some of the components may be connected to each other and exchange signals (commands, data, etc.) through a communication method between peripheral devices (a bus, general purpose input and output (GPIO), a serial peripheral interface (SPI), a mobile industry processor interface (MIPI), etc.)

Commands or data may be transmitted or received between the electronic device ED01 and an external device such as the electronic device ED04 through the server ED08 connected to the second network ED99. The other electronic devices ED02 and ED04 may be the same as or different from the electronic device ED01. All or some of the operations of the electronic device ED01 may be executed by one of the other electronic devices ED02, ED04, and ED08. For example, when the electronic device ED01 needs to perform certain functions or services, the electronic device ED01 may request one other electronic devices to perform some or all of the functions or services instead of directly executing the functions or services. One other electronic devices that have received the request may execute an additional function or service related to the request, and may transfer results of the execution to the electronic device ED01. To this end, cloud computing, distributed computing, and/or client-server computing techniques may be used.

Referring to FIG. 25, the camera module ED80 may include a lens assembly 1110, a flash 1120, an image sensor 1000 (refer to the image sensor 1000 shown in FIG. 1 etc.), an image stabilizer 1140, a memory 1150 (a buffer memory, etc.), and/or an image signal processor 1160. The lens assembly 1110 may collect light coming from an object to be imaged. The camera module ED80 may include a plurality of lens assemblies 1110, and in this case, the camera module ED80 may be a dual camera, a 360-degree camera, or a spherical camera. Some of the plurality of lens assemblies 1110 may have the same lens properties (field of view, focal length, autofocus, F Number, optical zoom, etc.) or different lens properties. Each of the lens assemblies 1110 may include a wide-angle lens or a telephoto lens.

The flash 1120 may emit light used to enhance light emitted or reflected from an object. The flash 1120 may include one light emitting diodes (a red-green-blue (RGB) LED, a white LED, an infrared LED, an ultraviolet LED, etc.), and/or a xenon lamp.

The image sensor 1000 may be the image sensor 1000 described with reference to FIGS. 1 to 5, any one of the various image sensors 1001, 1002, 1003, 1004, 1005, 1006, and 1007 according to other various example embodiments, or an image sensor resulted from combining or modifying the image sensors 1001, 1002, 1003, 1004, 1005, 1006, and 1007. The image sensor 1000 may acquire an image of an object by receiving light output or reflected from the object and transmitted through the lens assembly 1110, and converting the light into an electrical signal. The image sensor 1000 may include one sensors selected from image sensors having different properties, such as an RGB sensor, a black and white (BW) sensor, an IR sensor, or a UV sensor. Each of the sensors included in the image sensor 1000 may be provided as a CCD sensor and/or a CMOS sensor.

The image stabilizer 1140 may move one lenses included in the lens assembly 1110 or the image sensor 1000 in a specific direction in response to a movement of the camera module ED80 or the electronic device ED01 including the camera module ED80, or may control operating characteristics of the image sensor 1000 (adjustment of read-out timing, etc.) to compensate for negative effects caused by movement. The image stabilizer 1140 may detect a movement of the camera module ED80 or the electronic device ED01 by using a gyro sensor or an acceleration sensor arranged inside or outside the camera module ED80. The image stabilizer 1140 may be an optical image stabilizer.

In the memory 1150, some or all of data obtained through the image sensor 1000 may be stored for the next image processing operation. For example, when a plurality of images are obtained at a high speed, the obtained original data (Bayer-patterned data, high-resolution data, etc.) may be stored in the memory 1150 and only a low-resolution image may be displayed. Then, the original data of a selected image (user selection, etc.) may be transferred to the image signal processor 1160. The memory 1150 may be integrated into the memory ED30 of the electronic device ED01 or may be configured as a separate memory that may be independently operated.

The image signal processor 1160 may perform one image processes on an image obtained through the image sensor 1000 or image data stored in the memory 1150. In addition, the one image processes may include depth map generation, three-dimensional modeling, panorama generation, feature point extraction, image synthesis, and/or image compensation (noise reduction, resolution adjustment, brightness adjustment, blurring, sharpening, softening, etc.) The image signal processor 1160 may control (exposure time control, read-out timing control, etc.) components (the image sensor 1000, etc.) included in the camera module ED80. An image processed by the image signal processor 1160 may be stored again in the memory 1150 for additional processing or may be provided to external components (the memory ED30, the display device ED60, the electronic device ED02, the electronic device ED04, the server ED08, etc.) of the camera module ED80. The image signal processor 1160 may be integrated into the processor ED20 or may be configured as a separate processor that operates independently of the processor ED20. When the image signal processor 1160 is provided separately from the processor ED20, an image processed by the image signal processor 1160 may be displayed on the display device ED60 after being further processed by the processor ED20.

The electronic device ED01 may include a plurality of camera modules ED80 having different attributes or functions. In this case, one of the plurality of camera modules ED80 may be a wide-angle camera, and another of the plurality of camera modules ED80 may be a telephoto camera. Similarly, one of the plurality of camera modules ED80 may be a front camera, and another of the plurality of camera modules ED80 may be a rear camera.

According to example embodiments, the image sensor1000 may be applied to a mobile phone or smartphone, a tablet or smart tablet, a digital camera or camcorder, a laptop computer, a television or smart television, etc. For example, the smartphone or the smart tablet may include a plurality of high-resolution cameras each having a high-resolution image sensor mounted thereon. The high-resolution cameras may be used to extract depth information of objects in an image, adjust out of focus of an image, or automatically identify objects in an image.

In addition, the image sensor 1000 may be applied to a smart refrigerator, a security camera, a robot, a medical camera, etc. For example, the smart refrigerator may automatically recognize food contained in the smart refrigerator by using the image sensor 1000, and may inform a user of whether a specific food is contained in the smart refrigerator, the type of food put into or out of the smart refrigerator, etc. through a smartphone. The security camera may provide an ultra-high-resolution image and may recognize an object or a person in the ultra-high-resolution image even in a dark environment owing to high sensitivity of the security camera. The robot may be sent to a disaster or industrial site that cannot be directly accessed by humans and may provide high-resolution images. The medical camera may provide a high-resolution image for diagnosis or surgery, and may have a dynamically adjustable field of view.

In addition, the image sensor 1000 may be applied to a vehicle. The vehicle may include a plurality of vehicle cameras arranged at various locations. Each of the vehicle cameras may include the image sensor image 1000 according to an example embodiment. The vehicle may use the vehicle cameras to provide a driver with various information about the interior or surroundings of the vehicle, and may provide information necessary for autonomous driving by automatically recognizing objects or people in images.

While the image sensor including the color separation lens array, and the electronic device including the image sensor have been described according to example embodiments with reference to the accompanying drawings, these are merely examples, and those of ordinary skill in the art will understand that various modifications and other example embodiments may be made therein. Therefore, the example embodiments should be considered in a descriptive sense only and not for purposes of limitation. The scope of the disclosure is not limited to the example embodiments described above but should be defined by the appended claims and equivalents thereof.

While the image sensor including the color separation lens array, and the electronic device including the image sensor have been described according to example embodiments with reference to the accompanying drawings, these are merely examples, and those of ordinary skill in the art will understand that various modifications and other example embodiments may be made therein. Therefore, the example embodiments should be considered in a descriptive sense only and not for purposes of limitation. The scope of the disclosure is not limited to the example embodiments described above but should be defined by the appended claims and equivalents thereof.

The above-described image sensor may apply the isolation structure of which width is adjusted for each pixel to the color filter array and/or the sensor substrate, and thus crosstalk between adjacent cells may be reduced.

It should be understood that example embodiments described herein should be considered in a descriptive sense only and not for purposes of limitation. Descriptions of features or aspects within each example embodiment should typically be considered as available for other similar features or aspects in other example embodiments. While one example embodiments have been described with reference to the figures, it will be understood by those of ordinary skill in the art that various changes in form and details may be made therein without departing from the scope as defined by the following claims.

## Claims

1. An image sensor comprising:
a sensor substrate comprising a plurality of light sensing cells configured to sense light; and
a color filter array provided on the sensor substrate, the color filter array comprising:
a plurality of filters provided to respectively face the plurality of light sensing cells to filter light of different wavelengths, and
a fence structure configured to separate the plurality of filters from each other,
wherein a width of the fence structure interposed between two adjacent filters, among the plurality of filters, has a plurality of different values according to a characteristics of each of the two adjacent filters, and
wherein a difference between a maximum value and a minimum value among the plurality of values is equal to or greater than 20 nm.

2. The image sensor of claim 1, wherein the fence structure comprises a material having a first refractive index lower than a second refractive index of each of the plurality of filters.

3. The image sensor of claim 1, wherein the plurality of filters comprise a red filter, a first green filter, a second green filter, and a blue filter arranged in a Bayer pattern.

4. The image sensor of claim 3, wherein the fence structure has a first width between the red filter and the first green filter and a second width between the first green filter and the blue filter, the first width being greater than the second width.

5. The image sensor of claim 3, wherein the fence structure has a third width between the red filter and the second green filter and a fourth width between the second green filter and the blue filter, the third width being greater than the fourth width.

6. The image sensor of claim 3, 4 or 5,
wherein a distance between centers of pixels adjacent to each other among a plurality of pixels is equal to or less than 0.6 µm, and
wherein the fence structure has two widths in a range from 50 nm to 200 nm.

7. The image sensor of any of claims 3 to 6, wherein the first green filter and the second green filter have a first area smaller than a second area of the blue filter and greater than a third area of the red filter.

8. The image sensor of any of claims 3 to 7, wherein the sensor substrate comprises an isolation structure configured to electrically separate the plurality of light sensing cells and arranged corresponding to the fence structure, and optionally wherein a width of the isolation structure varies according to a type of a filter facing two adjacent light sensing cells, between which the isolation structure is interposed .

9. The image sensor of claim 8,
wherein the plurality of light sensing cells comprise a red pixel, a first green pixel, a second green pixel, and a blue pixel facing the red filter, the first green filter, the second green filter, and the blue filter, respectively, and
wherein a first width of the isolation structure between the red pixel and the first green pixel is less than a second width of the isolation structure between the first green pixel and the blue pixel, and optionally wherein a third width of the isolation structure between the red pixel and the second green pixel is less than a fourth width of the isolation structure between the second green pixel and the blue pixel,
and further optionally wherein: the first green filter and the second green filter have a first area greater than a second area of the red pixel; and
the second area of the red pixel is greater than a third area of the blue pixel.

10. The image sensor of claim 8 or 9,
wherein a distance between centers of pixels adjacent to each other among a plurality of pixels is equal to or less than 0.6 µm, and
wherein the isolation structure has two widths in a range from 50 nm to 180 nm.

11. The image sensor of claim 8, 8 or 10, wherein the fence structure and the isolation structure are vertically connected to each other.

12. The image sensor of any preceding claim, wherein the plurality of filters comprise:
a red filter group comprising four red filters;
a first green filter group comprising four first green filters;
a second green filter group comprising four second green filters; and
a blue filter group comprising four blue filters, and
wherein the red filter group, the first green filter group, the second green filter group, and the blue filter group are arranged in a Bayer pattern, and optionally wherein a width of the fence structure between filters of a same color is different from a width of the fence structure between filters of different colors.

13. The image sensor of claim 12, wherein widths of the fence structure between filters of a same color are different from each other in two or more filter groups.

14. The image sensor of claim 12 or 13, wherein a width of the fence structure between the red filter and the first green filter adjacent to each other between the red filter group and the first green filter group is different from a width of the fence structure between the first green filter and the blue filter adjacent to each other between the first green filter group and the blue filter group.

15. An electronic device comprising:
an image sensor according to any preceding claim configured to convert an optical image into an electrical signal; and
a processor configured to control an operation of the image sensor and process a signal generated by the image sensor.
